# EUROPEAN PATENT SPECIFICATION

(11) **EP 0 319 223 B1**
(45) Date of publication and mention of the grant of the patent: **09.11.1994**
(21) Application number: 88311245.0
(22) Date of filing: 28.11.1988
(51) Int. Cl.: G11C 7/00, G11C 11/419

(54) **An output circuit system of static random access memory circuit**
Ausgabeschaltungssystem eines statischen RAM-Speichers
Système de circuit de sortie d'un circuit de mémoire RAM statique

(30) Priority: 03.12.1987 JP 306345/87
(43) Date of publication of application: 07.06.1989
(73) Proprietor: Matsushita Electronics Corporation, Kadoma-shi, Osaka 571 (JP)
(72) Inventor: Okuyama, Hiroaki, Katsura Nishikyou-ku Kyoto Kyoto (JP)
(74) Representative: Crawford, Andrew Birkby

(56) References cited:
- EP-A- 0 090 590
- GB-A- 2 185 649
- US-A- 4 272 834
- PATENT ABSTRACTS OF JAPAN, vol. 6, no. 2 (P-69)[880], 8th January 1982;& JP-A-56 127 990

## Description

This invention relates to an output circuit system of a static random access memory circuit (hereinafter called SRAM).

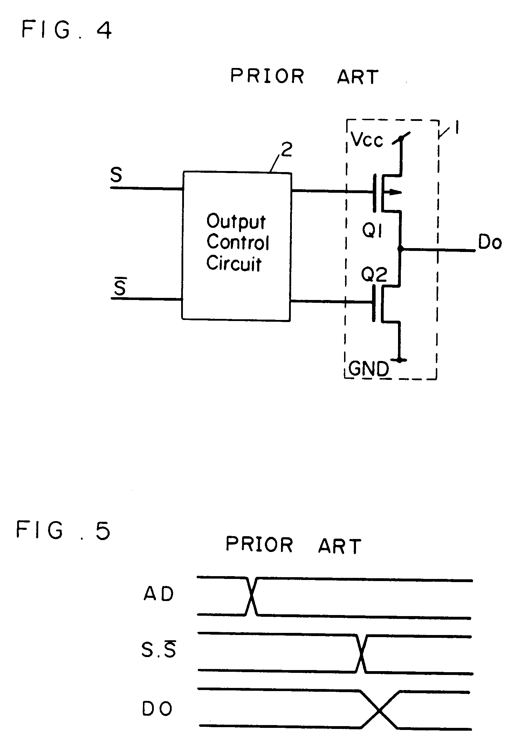

Fig. 4 is an output circuit of a conventional SRAM, and Fig. 5 shows a timing chart of the output circuit in Fig. 4.

In Fig. 4, multiple memory cells arranged in matrix in a memory cell block (not shown) contain data of "1" or "0" individually, and when one memory cell is selected by address signal AD, the data of "1" or "0" stored in that memory cell is read out. If the data being read out is "1", the internal data S in Fig. 4 becomes high level (H level) and the internal data S̅ becomes low level (L level). To the contrary, if the data being read out is "0", the internal data S in Fig. 4 becomes L level and the internal data S̅ becomes H level. An output control circuit 2 controls the gates of MOS FET Q₁, Q₂ of a data output circuit 1 according to the potential levels of internal data S, S̅, and establishes the output Do at H level or L level. For example, when the internal data S is H level and internal data S̅ is L level (in other words, when the data stored in the selected memory cell is "1"), the both gates of MOS FET Q₁, Q₂ of the data output circuit 1 are set at L level, and only the P-channel MOS FET Q₁ is turned on, and the output Do is pulled up to H level. To the contrary, when the internal data S is L level and internal data S̅ is H level (in other words, when the data stored in the selected memory cell is "0"), the both gates of MOS FET Q₁, Q₂ of the data output circuit 1 are set to H level, and only the N-channel MOS FET Q₂ is turned on, and the output Do is pulled down to L level.

Therefore, when the address signal AD changes, the internal data S, S̅ change from H level to L level or vice versa, and according to this change the output control circuit 2 controls the gate potentials of MOS FET Q₁, Q₂ of the data output circuit 1, and the final output Do changes from H level to L level or vice versa. Fig. 5 shows such potential changes.

In the conventional composition, however, the output Do changes largely from H level (≃ V cc) to L level (≃ 0V), or from L level (≃ 0V) to H level (≃ V cc). Generally, since the load connected to the output terminal of SRAM has extremely large capacity, if the potential change of the output Do is large, the transition time until the output Do settles at a stable value of H level or L level is long, and the reading action of the SRAM cannot be increased in speed. Besides, since the output Do changes largely, a large momentary current flows through MOS FET Q₁, Q₂ of the output circuit 1.

It is hence a primary object of this invention to present an output circuit system of SRAM capable of operating the SRAM at high speed by shortening the transition time of the output potential.

It is a second object of this invention to present an output circuit system of SRAM reducing the momentary current flowing through the MOSFET of data output circuit.

GB-A-2185649 describes a semiconductor memory device comprising the features of the preamble of claim 1 in which a desired output signal line is held at a middle potential by using an internal synchronous signal generated in response to change in an address signal extremely applied, so that fast operation is ensured. The middle potential is supplied to the bus line which supplies the output buffer and helps to avoid delays in changes from high to low potential caused by parasitic capacitances in the data bus.

The present invention provides an output circuit system of static random access memory comprising:
a memory cell block containing plural memory cells;
output control means for receiving internal data changed depending on the data in any one of said plural memory cells selected by an address signal; data output means providing an output potential at a level corresponding to data in said selected memory cell; and
intermediate potential setting means operative in response to a transition of said address signal;
wherein said output control means changes said output potential of said data output means from said intermediate potential to a potential corresponding to a data in said selected memory cell, after transition of said address signal and after change of said internal data;
characterised in that:
said data output means comprises P-channel and N-channel MOSFETs having their sources connected to two supply potentials and their gates supplied with an output signal of said output control means whereby to provide said output potential at a connection point of their drains; and
said intermediate potential setting means is connected to the input of the data output means and operates to set the output potential of said data output means to an intermediate potential between an immediate preceding output potential of said data output means and one of said supply potentials after a transition of said address signal and before a change of said internal data depending on data in a selected memory cell.

Embodiments of the invention will now be described by way of example only and with reference to the accompanying drawings in which:
FIGURE 1 is a block diagram of an output circuit system of SRAM in an embodiment of the invention;
FIGURE 2 is a timing chart of essential parts of Figure 1;
FIGURE 3 is a block diagram of an output circuit system of SRAM in a more practical embodiment of the invention;
FIGURE 4 is a block diagram of an output circuit system of a conventional SRAM; and
Fig. 5 is a timing chart of essential parts of Fig. 4.

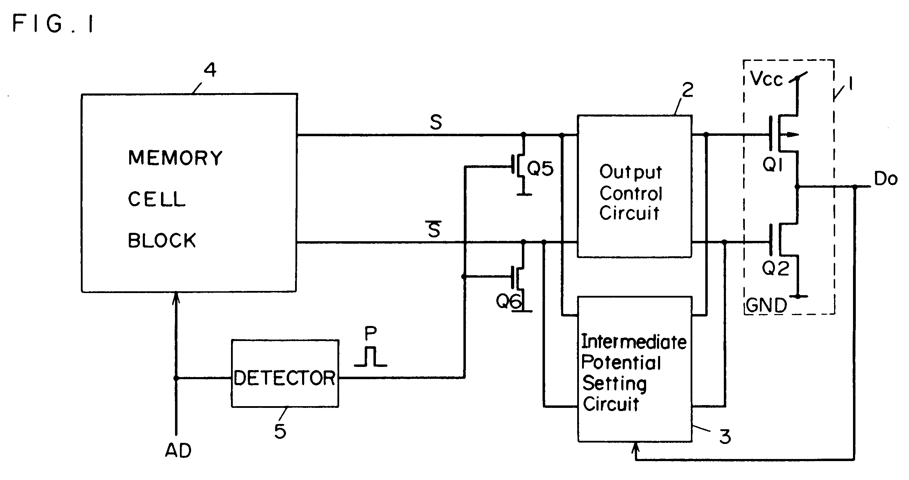

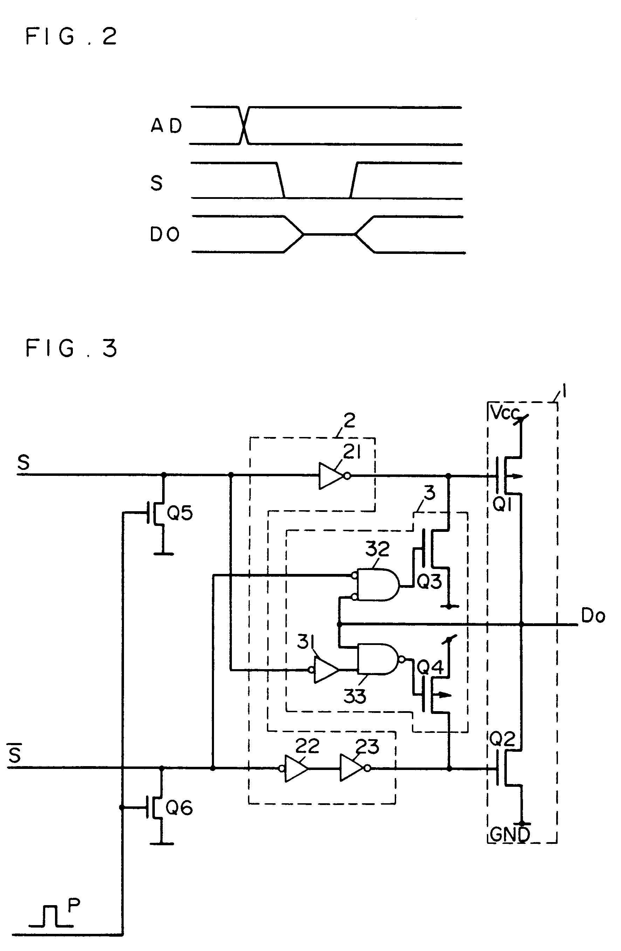

Referring now to Figs. 1, 2, an embodiment of the invention is described below. In Fig. 1, a memory cell block 4 contains, among others, a memory cell matrix, an address decoder for selecting a memory cell in the memory cell matrix and a data reading circuit for reading out the data stored in each memory cell. Similarly to the prior art, data of "1" or "0" is read out from the memory cell (not shown) selected by address signal AD. Depending on whether this data read out from the memory cell is "1" or "0", the internal data S, S̅ become H level or L level. The data S, S̅ are supplied into the output control circuit 2, and also into an intermediate potential setting circuit 3. On the other hand, between data wires of internal data S, S̅ and the reference potential, MOS FET Q₅, Q₆ are connected, and the pulse generated by an address transition detector 5 for detecting the transition of address signal AD is applied to the gates of the MOS FET Q₅, Q₆. Therefore, the internal data S, S̅ both change once to L level every time the address signal AD is changed, and thereafter they change to the level depending on the data in the selected memory cell. The output of the intermediate potential setting circuit 3 is supplied into the gates of the MOS FET Q₁, Q₂ of the data output circuit 1, together with the output of the output control circuit 2. The output Do of the data output circuit 1 is supplied into the intermediate potential setting circuit 3 in order to control the action of the intermediate potential setting circuit 3.

The operation of thus composed output circuit system of SRAM of this embodiment is explained below.

When a certain memory cell is selected by an address signal AD, the internal data S, S̅ are determined depending on the data stored in that memory cell. Accordingly, depending on the internal data S, S̅, the output control circuit 2 controls the on/off switching of MOS FET Q₁, Q₂ in the data output circuit 1, so that the output Do is established at L level or H level. At this time, the intermediate potential setting circuit 3 is in inactive state.

Next, when the address signal AD is changed in order to select other memory cell, the address transition detector 5 detects instantly the transition of address signal AD, and generates a detection pulse P. The detection pulse P is applied to the gates of MOS FET Q₅, Q₆ to turn on both Q₅ and Q₆, thereby changing the internal data S, S̅ both to L level. In this way, the internal data S, S̅ change to L level for a specific period before the internal data S, S̅ change to the level corresponding to the data in the memory cell, so that the transition of the address signal AD may be detected. Thus, when the internal data S, S̅ both become L level, the intermediate potential setting circuit 3 is set in active state. When the intermediate potential setting circuit 3 comes into active state, the output Do is, if it is H level at that moment, lowered to the intermediate point. Or if it is L level at that moment, the output Do is pulled up to the intermediate potential.

Afterwards, the data of the memory cell selected by the address signal Ad is read out, and the internal data S, S̅ change to H level or L level, when the intermediate potential setting circuit 3 is set again to inactive state, and thereafter the output control circuit 2 controls the on/off switching of MOS FET Q₁, Q₂ of the data output circuit 1 depending on the state of the internal data S, S̅, and the output Do is changed from the intermediate potential to H level or from the intermediate potential to L level. Fig. 2 shows the changes of the address signal AD, data S, and output Do level at this time.

Thus, according to the embodiment in Fig. 1, after transition of the address signal AD, and before the levels of the internal data S, S̅ are changed to the level corresponding to the data read out from the memory cell, the potential level of the output Do is detected by the intermediate potential setting circuit 3 so that the output Do may be preliminarily set to an intermediate potential. Therefore, afterwards, when the internal data S, S̅ are changed to the level corresponding to the data read out from the memory cell, the output Do may be always changed from the intermediate potential to H level or from the intermediate potential to L level. Accordingly, the transition time of the output Do may be shortened, and high speed reading action of the SRAM may be realized. It is also possible to reduce the momentary current flowing through MOS FET Q₁, Q₂ of the data output circuit 1.

Fig. 3 shows a more practical embodiment of this invention.

In Fig. 3, an output control circuit 2 is composed of inverters 21, 22, 23. An intermediate potential setting circuit 3 is composed of inverter 31, NOR gate 32, NAND gate 33, N-channel MOS FET Q₃, and P-channel MOS FET Q₄. The output Do of a data output circuit 1 is supplied into one of the input terminals of NOR gate 32, and NAND gate 33, respectively. The internal data S is applied to the gate of the MOS FET Q₁ of data output circuit 1 by way of the inverter 21 of the output control circuit 2, and is also supplied into the other one of the input terminals of NAND gate 33 by way of the inverter 31 of the intermediate potential setting circuit 3. On the other hand, the internal data S̅ is applied to the gate of MOS FET Q₂ of data output circuit 1 by way of the inverters 22, 23 of the output control circuit 2, and is also applied to the other one of the input terminals of NOR gate 32 of the intermediate potential setting circuit 3. The outputs of the NOR gate 32 and NAND gate 33 are applied to the gates of MOS FET Q₃, Q₄ respectively. The source and drain of MOS FET Q₃ are connected respectively to the output terminal of the inverter 21 and reference potential point, while the source and drain of MOS FET Q₄ are connected to the supply potential Vcc and output terminal of the inverter 23.

The operation of the consitution in Fig. 3 is as follows.

When a certain memory cell is selected and the data "1" stored in that memory cell is read out, the internal data S is at H level and the internal data S̅ is at L level, and the output Do is at H level. At this time, the output of NOR gate 32 becomes L level, and the MOS FET Q₃ becomes OFF. By contrast, the output of NAND gate 33 becomes H level, and the MOS FET Q₄ becomes OFF. That is, the intermediate potential setting circuit 3 is in inactive state, and the output Do is fixed at H level. When the data "0" stored in the memory cell is read out, the intermediate potential setting circuit 3 is in inactive state in the same theory as stated above, and the output Do is fixed at L level.

Next, by transition of the address signal AD, when other memory cell is accessed, the change of address signal AD is detected, and a detection pulse P is generated, and the MOS FET Q₅ and Q₆ are both turned on, and the internal data S, S̅ potentials are lowered to L level. As a result, if the previous output Do is at H level, the two inputs of the NAND gate 33 both become H, and the output of the NAND gate 33 becomes L level, and the MOS FET Q₄ becomes into active state. On the other hand, the two inputs of the NOR gate 32 are H level and L level individually, and the output of NOR gate 32 is at L level, and the MOS FET Q₃ remains in OFF state. Therefore, the gate of MOS FET Q₂ of the data output circuit 1 becomes H level, and the MOS FET Q₂ becomes into active state, and the output Do is pulled down to the intermediate potential between H level and reference potential (GND). To the contrary, when the output Do before generation of detection pulse P is L level, the MOS FET Q₁ of the data output circuit 1 becomes into active state, and the MOS FET Q₂ is turned off, and the output Do is pulled up to the intermediate potential between L level and supply potential (Vcc).

In consequence, when the data of "1" or "0" is read out from the selected memory cell, the internal data, S, S̅ are changed to H level or L level, and correspondingly the MOS FET Q₁, Q₂ of the data output circuit 1 are controlled in on/off switching, and the outpu Do is pulled up (or down) from the intermediate potential to H level (or L level).

According to the embodiment in Fig. 3, in this way, the transition of address signal AD is detected, and the potential of the output Do is preliminarily set at intermediate potential, and then the potential is changed from the intermediate potential to H level or L level, and therefore the transition time of the output Do is shortened, and high-speed reading action is realized, and the momentary current flowing through the data output circuit may be decreased.

Incidentally, in the embodiments shown in Fig. 1 and Fig. 3, MOS FET Q₅, Q₆ are provided in order to detect the transition of address signal, and the MOS FET Q₅, Q₆ are turned on by the address transition detection pulse P, and the internal data S, S̅ are once changed to L level, but this invention is not limited to this method alone. For example, it may be possible to connect the MOS FET Q₅, Q₆ between the wires of internal data S, S̅ and supply potential (Vcc), and change the internal data S, S̅ to H level for a specific period. In this case, too, only by rearranging the logic gates of the intermediate potential setting circuit 3, the same operation as in the embodiment in Fig. 3 may be realized. Besides, instead of changing the internal data S, S̅ to L level or H level for a specific period by the transition of address signal, a signal to express such transition of the address signal (for example, the address transition detection pulse in Fig. 1, Fig. 3) may be directly applied to the intermediate potential setting circuit. In this case, again, the same operation as in the embodiment in Fig. 3 may be realized only by rearranging the logic gates.

## Claims

1. An output circuit system of static random access memory comprising:
a memory cell block (4) containing plural memory cells;
output control means (2) for receiving internal data changed depending on the data in any one of said plural memory cells selected by an address signal (AD);
data output means (1) providing an output potential at a level corresponding to data in said selected memory cell; and
intermediate potential setting means (3) operative in response to a transition of said address signal;
wherein said output control means (2) changes said output potential of said data output means from said intermediate potential to a potential corresponding to a data in said selected memory cell, after transition of said address signal and after change of said internal data;
characterised in that:
said data output means comprises P-channel and N-channel MOSFETs (Q1,Q2) having their sources connected to two supply potentials and their gates supplied with an output signal of said output control means (2) whereby to provide said output potential at a connection point of their drains; and
said intermediate potential setting means is connected to the input of the data output means and operates to set the output potential of said data output means to an intermediate potential between an immediately preceding output potential of said data output means and one of said supply potentials after a transition of said address signal and before a change of said internal data depending on data in a selected memory cell.

2. An output circuit system of static random memory according to claim 1, wherein internal data converting means (Q5,Q6) for detecting the transition of said address signal and changing said internal data to L level or H level for a specific period is disposed at an input side of said output control means, and an output of said internal data converting means is supplied to said intermediate potential setting means (3).

3. An output circuit system of static random access memory according to claim 1 or 2, wherein an electric signal (P) generated by detection of transition of said address signal is directly applied into said intermediate potential setting means (3).

4. An output circuit system of static random access memory according to claim 1, wherein said intermediate potential setting circuit (3) comprises:
first switching means (Q3) connected between a gate of one MOSFET (Q1) of said data output means and a supply of low potential; and
second switching means (Q4) connected between a gate of the other MOSFET (Q2) of said data output means and a supply of high potential, in which when said address signal transits while the output potential of said data output means (1) is in H level state, said second switching means (Q4) becomes active in order to activate the other MOSFET of said data output means (Q2), and an output potential of said data output means (1) is set at an intermediate potential between the H level and said low potential, and when said address signal transits while the output potential of said data output means is in L level state, said first switching means (Q3) becomes active in order to activate said one MOSFET (Q1) of said data output means (1), and an output potential of said data output means is set at an intermediate potential between the L level and said high potential.

## Patentansprüche

1. Ausgangsschaltungssystem eines statischen Direktzugriffspeichers, das umfaßt:
einen Speicherzellenblock (4), der mehrere Speicherzellen enthält:
eine Ausgangssteuereinrichtung (2), die interne Daten empfängt, die in Abhängigkeit von den Daten in einer der Vielzahl von Speicherzellen geändert werden, die durch ein Adressensignal (AD) ausgewählt wird;
Datenausgangseinrichtung (1), die ein Ausgangspotential auf einem Pegel erzeugt, der Daten in der ausgewählten Speicherzelle entspricht; und
eine Zwischenpotential-Einstelleinrichtung (3), die in Reaktion auf einen Übergang des Adressensignals arbeitet;
wobei die Ausgangssteuereinrichtung (2) das Ausgangspotential der Datenausgangseinrichtung nach dem Übergang des Adressensignals und nach der Änderung der internen Daten von dem Zwischenpotential auf ein Potential ändert, das Daten in der ausgewählten Speicherzelle entspricht;
**dadurch gekennzeichnet**, daß die Datenausgangseinrichtung einen p-Kanal- und einen n-Kanal-MOSFET (Q1, Q2) umfaßt, deren Sourcen an zwei Speisepotentiale angeschlossen sind, und deren Gates ein Ausgangssignal der Ausgangssteuereinrichtung (2) zugeführt wird, wodurch das Ausgangspotential an einem Verbindungspunkt ihrer Drains erzeugt wird; und
daß die Zwischenpotential-Einstelleinrichtung mit dem Eingang der Datenausgangseinrichtung verbunden ist und das Ausgangspotential der Datenausgangseinrichtung nach dem Übergang des Adressensignals und vor einer Änderung der internen Daten in Abhängigkeit von den Daten in einer ausgewählten Speicherzelle auf ein Zwischenpotential zwischen einem unmittelbar vorhergehenden Ausgangspotential der Datenausgangseinrichtung und einem der Speisepotentiale einstellt.

2. Ausgangsschaltungssystem eines statischen Direktzugriffspeichers nach Anspruch 1, wobei sich eine interne Datenumwandlungseinrichtungen (Q5, Q6) zum Erfassen des Übergangs des Adressensignals und zur Änderung der internen Daten auf L-Pegel oder H-Pegel über einen bestimmten Zeitraum an einer Eingangsseite der Ausgangssteuereinrichtung befinden, und ein Ausgang der internen Datenumwandlungseinrichtungen der Zwischenpotential-Einstelleinrichtung (3) zugeführt wird.

3. Ausgangsschaltungssystem eines statischen Direktzugriffspeichers nach Anspruch 1 oder 2, wobei ein elektrisches Signal (P), das durch die Erfassung des Übergangs des Adressensignals erzeugt wird, direkt der Zwischenpotential-Einstelleinrichtung (3) zugeführt wird.

4. Ausgangsschaltungssystem eines statischen Direktzugriffspeichers nach Anspruch 1, wobei die Zwischenpotential-Einstellschaltung(3) umfaßt:
eine erste Schalteinrichtung (Q3), die zwischen ein Gate eines MOSFET (Q1) der Datenausgangseinrichtung und eine Speisequelle mit niedrigem Potential geschaltet ist; und
eine zweite Schalteinrichtung (Q4), die zwischen ein Gate des anderen MOSFET (Q2) der Datenausgangseinrichtung und eine Speisequelle mit hohem Potential geschaltet ist,
wobei, wenn das Adressensignal einen Übergang erfährt, während sich das Ausgangspotential der Datenausgangseinrichtung (1) im H-Pegelzustand befindet, die zweite Schalteinrichtung (Q4) aktiv wird und den anderen MOSFET der Datenausgangseinrichtung (Q2) aktiviert, und ein Ausgangspotential der Datenausgangseinrichtung (1) auf ein Zwischenpotential zwischen dem H-Pegel und dem niedrigen Potential eingestellt wird, und, wenn das Adressensignal einen Übergang erfährt, während sich das Ausgangspotential der Datenausgangseinrichtung im L-Pegelzustand befindet, die erste Schalteinrichtung (Q3) aktiv wird und den einen MOSFET (Q1) der Datenausgangseinrichtung (1) aktiviert, und ein Ausgangspotential der Datenausgangseinrichtung auf ein Zwischenpotential zwischen dem L-Pegel und dem hohen Potential eingestellt wird.

## Revendications

1. Système pour circuit de sortie de mémoire vive statique, comprenant :
un bloc (4) de cellules de mémoire contenant plusieurs cellules de mémoire ;
un moyen (2) de commande de sortie destiné à recevoir une donnée interne modifiée en fonction de la donnée de l'une quelconque desdites cellules de mémoire qui a été sélectionnée par un signal d'adresse (AD) ;
un moyen (1) de sortie de données produisant un potentiel de sortie dont le niveau correspond à la donnée se trouvant dans ladite cellule de mémoire sélectionnée ; et
un moyen (3) de fixation de potentiel intermédiaire, intervenant en réponse à une transition dudit signal d'adresse ;
où ledit moyen de commande de sortie (2) modifie ledit potentiel de sortie dudit moyen de sortie de données en le faisant passer dudit potentiel intermédiaire à un potentiel qui correspond à une donnée se trouvant dans ladite cellule de mémoire sélectionnée, après la transition dudit signal d'adresse et après la modification de ladite donnée interne ;
caractérisé en ce que :
ledit moyen de sortie de données comprend des transistors à effet de champ métal-oxyde-semiconducteur (MOSFET) à canal P et à canal N (Q1, Q2) dont les sources sont connectées à deux potentiels d'alimentation et dont les grilles reçoivent un signal de sortie dudit moyen de commande de sortie (2) de manière à produire ledit potentiel de sortie au point de connexion de leurs drains ; et
ledit moyen de fixation de potentiel intermédiaire est connecté à l'entrée du moyen de sortie de données et agit de façon à fixer le potentiel de sortie dudit moyen de sortie de données sur un potentiel intermédiaire compris entre un potentiel de sortie immédiatement précédent dudit moyen de sortie de données et l'un desdits potentiels d'alimentation, après une transition dudit signal d'adresse et avant une modification de ladite donnée interne en fonction d'une donnée se trouvant dans une cellule de mémoire sélectionnée.

2. Système pour circuit de sortie de mémoire vive statique selon la revendication 1, où un moyen (Q5, Q6) de conversion de donnée interne, servant à détecter la transition dudit signal d'adresse et à modifier ladite donnée interne en la faisant passer à un niveau bas (L) ou un niveau haut (H) pendant une durée spécifiée, est disposé du côté entrée dudit moyen de commande de sortie, et un signal de sortie dudit moyen de conversion de donnée interne est fourni audit moyen de fixation de potentiel intermédiaire (3).

3. Système pour circuit de sortie de mémoire vive statique selon la revendication 1 ou 2, où un signal électrique (P) produit par détection d'une transition dudit signal d'adresse est directement appliqué audit moyen de fixation de potentiel intermédiaire (3).

4. Système pour circuit de sortie de mémoire vive statique selon la revendication 1, où ledit circuit de fixation de potentiel intermédiaire (3) comprend :
un premier moyen de commutation (Q3) connecté entre la grille de l'un (Q1) des MOSFET dudit moyen de sortie de données et une alimentation en potentiel bas ;
un deuxième moyen de commutation (Q4) connecté entre la grille de l'autre MOSFET (Q2) dudit moyen de sortie de données et une alimentation en potentiel haut, où, lorsque ledit signal d'adresse effectue une transition alors que le potentiel de sortie dudit moyen de sortie de données (1) est dans l'état de niveau H, ledit deuxième moyen de commutation (Q4) devient actif afin d'activer l'autre MOSFET (Q2) dudit moyen de sortie de données et un potentiel de sortie dudit moyen de sortie de données (1) est fixé à un potentiel intermédiaire compris entre le niveau H et ledit potentiel bas, et, lorsque ledit signal d'adresse effectue une transition alors que le potentiel de sortie dudit moyen de sortie de données est dans l'état de niveau L, ledit premier moyen de commutation (Q3) devient actif afin d'activer ledit MOSFET premier cité (Q1) dudit moyen de sortie de données (1) et un potentiel de sortie dudit moyen de sortie de données est fixé à un potentiel intermédiaire compris entre le niveau L et ledit potentiel haut.
